Europäisches Patentamt

European Patent Office

Office européen des brevets

(11) Publication number: **0 223 188 B1**

## EUROPEAN PATENT SPECIFICATION

(45) Date of publication of patent specification: **07.10.92**　(51) Int. Cl.5: **G11C 29/00**

(21) Application number: **86115639.6**

(22) Date of filing: **11.11.86**

(54) Semiconductor programmable memory device.

(30) Priority: **20.11.85 JP 260493/85**

(43) Date of publication of application:
**27.05.87 Bulletin 87/22**

(45) Publication of the grant of the patent:
**07.10.92 Bulletin 92/41**

(84) Designated Contracting States:
**DE FR GB**

(56) References cited:

PATENT ABSTRACTS OF JAPAN, vol. 5, no. 77 (P-62)[749], 21st May 1981; & JP-A-56 25 295 (NIPPON DENKI K.K.) 11-03-1981

INTEGRATION TO VLSI JOURNAL, vol. 2, no. 4, December 1984, pages 309-330, Elsevier Science Publishers B.V. (North-Holland), Amsterdam, NL; K.K. SALUJA et al.: "Testable design of large random access memories"

DIGEST OF TECHNICAL PAPERS OF THE 1983 IEEE INTERNATIONAL SOLID-STATE CIRCUITS CONFERENCE, February 1983, pages 164-165, IEEE, New York, US; A. LANCASTER et al.: "A 5V-only EEPROM with in-ternal program/erase control"

IEEE JOURNAL OF SOLID-STATE CIRCUITS, vol. SC-14, no. 4, August 1979, pages 730-734, IEEE, New York, US; R. KONDO: "Test patterns for EPROM's"

(73) Proprietor: **FUJITSU LIMITED**
**1015, Kamikodanaka Nakahara-ku**
**Kawasaki-shi Kanagawa 211(JP)**

(72) Inventor: **Kawashima, Hiromi**
**Noguchiso 1 805, Kosugigotencho 1-chome**
**Nakahara-ku Kawasaki-shi Kanagawa,**
**211(JP)**
Inventor: **Arakawa, Hideki**
**Asahiso 13-17, Umegaoka Midori-ku**
**Yokohama-ku Kawasaki-shi Kanagawa,**
**227(JP)**

(74) Representative: **Schmidt-Evers, Jürgen,**
**Dipl.-Ing. et al**
**Patentanwälte Dipl.-Ing. H. Mitscherlich**
**Dipl.-Ing. K. Gunschmann Dipl.-Ing.**
**Dr.rer.nat. W. Körber Dipl.-Ing. J. Schmidt-**
**Evers Dipl.-Ing. W. Melzer Steinsdorfstrasse**
**10**
**W-8000 München 22(DE)**

## Description

The present invention generally relates to a semiconductor programmable memory device, especially to an electrically erasable programmable read only memory (abbreviated as EEPROM or E²PROM) device. This invention is involved in a circuit configuration which reduces a time to check the performance of the E²PROM.

The test of a semiconductor memory device is done by writing a predetermined pattern such as a checker board pattern in its memory matrix, and reading it out. The checker board pattern is composed of "1" and "0" written alternately in each of the memory cells, and as a whole, the memory matrix is patterned like a checker board.

Though the read out process of a E²PROM is done very quickly, however, the writing process into a memory cell of the E²PROM takes a long time. For example, it takes approximately 10 ms for writing or erasing a byte, so it takes more than a minute to "write" the checker pattern in a 64 k bits E²PROM. As the memory scale becomes large, therefore, the time to write in a checker pattern, and hence the checking time becomes very long.

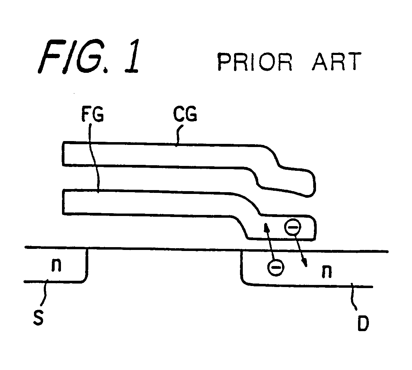

In order to render clearly apparent the advantage of the present invention, a structure and working process of prior art E²PROM will be described briefly. Fig. 1 shows schematically a cross sectional view of a memory transistor used in a memory cell of an E²PROM. S and D indicates respectively a source and drain of an n-channel floating gate memory cell, CG is a control gate and FG is a floating gate. In the E²PROM, when electrons are accumulated in the floating gate FG, the memory transistor is cut off, such process is called as an "erase" operation, and a datum "1" is written in the memory cell. When the electrons are discharged from the floating gate FG, the memory transistor becomes an ON state, such process is called as a "write" operation, and a datum "0" is written in the memory cell.

In the structure of the memory cell of Fig. 1, the isolation layer between the floating gate FG and the drain D is fabricated very thin. So, electrons can pass through the insulation layer by tunnel effect when a high voltage is applied between the floating gate FG and the drain D. In order to do the "erase" operation in a memory cell, a high voltage Vpp (21 volts for example) is applied to the control gate CG, and the voltage of the drain D is kept to 0 volt. Then the voltage of the floating gate FG is increased by a coupling capacity between both gates, so, electrons are injected from the drain D into the floating gate FG by a tunnel effect, and a datum "1" is written in. On the contrary, in order to do the "write" operation, the voltage of the control gate CH is kept 0, and a high voltage Vpp is applied to the drain D. So, the electrons on the floating gate FG are discharged to the drain D by the tunnel effect, and a datum '0" is written in the memory cell.

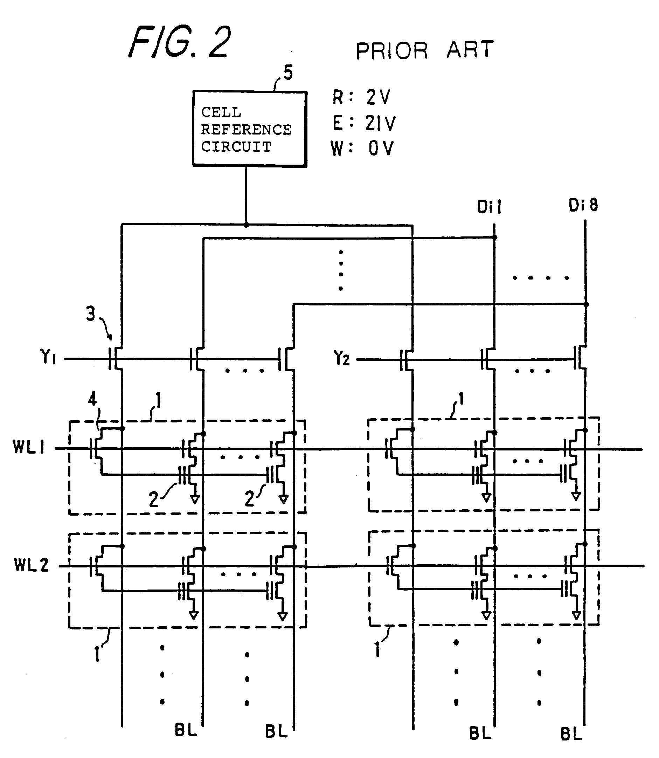

Fig. 2 is a circuit diagram of a conventional E²PROM showing a part relevant to the present invention. A fundamental process to write data in the memory cells of prior art EEPROM device will be explained briefly referring to Fig. 2. The description will be given, as an example, with respect to a memory matrix whose byte is composed of 8 bits. In the figure, word lines WL1, WL2 • • • are arranged in X direction, and bit lines BL are arranged in Y direction. At each cross points of the word lines and the bit lines is provided a memory cell 2. Each of the memory cells 2 is composed of a memory transistor having a floating gate, and a MOS-FET (metal-oxide-semiconductor type field effect transistor). Each eight memory cells on a word line composed a memory array 1 for one byte composed of eight bits.

In order to control the eight memory cells of each byte, a gate controlling transistor 4 is provided respectively to the memory arrays 1. It controls the voltage of the control gates of each memory transistors. The gates of these gate controlling transistors 4 are also connected to respective word line.

Usually, as can be seen in Fig. 2, the memory arrays 1 are arranged in several number of columns, and data input lines Di1, Di2 • • • Di8 are connected in parallel to each columns and compose the bit lines BL. On each of the bit lines BL is provided a Y-gate transistors 3. Each gate of the Y-gate transistors in the column are connected to each other and composes respectively the gates Y1, Y2 • • •. In the description hereinafter, the control signals to control these gates of the columns which are controlled by these gates are also referred to as control signals Y1, Y2 • • • or columns Y1, Y2 • • • respectively. 5 is a built in cell reference circuit which provides reference voltages of 0, 21, and 2 volts respectively for the write, erase and read operations. These reference voltages are supplied to the gate controlling transistors 4 via the Y-gate transistors 3 for controlling the control gates of the memory transistors.

In such circuit configuration, a specific byte is identified by a cross point of the column and word line where it is located, and the byte is selected by applying a control signal to the transistors 3 and 4 corresponding to the specific byte and make them conductive. A fundamental process to erase and to write in the memory matrix will be explained referring to Fig. 2.

In order to "erase" a specific byte (Y1,WL1) for example, the output voltage of the cell reference circuit 5 is increased to a high voltage Vpp, and the voltage of the bit lines are kept to 0 volt. By doing so, the high voltage Vpp is applied to the control gates of the memory transistors in the specific byte (Y1,WL1), and the drain voltages of them become 0 volt. So, these memory transistors begin the "erase" operation which has been described before with respect to Fig. 1, and "1" is written in each of the memory cells of the byte (Y1,WL1).

In order to "write" the specific byte (Y1,WL1) for example, the Y-gate Y1 and the word line WL1 are selected, the output voltage of the cell reference circuit 5 is decreased to 0 volt, and the voltage of the bit lines are increased to Vpp. Then the memory transistors of the specific byte begins the "write" operation as has been described before, and "0" is written in each of the memory cells of the byte (Y1,WL1).

As have been mentioned before, in order to test the programmable ROM (read only memory), it is necessary to write in the memory matrix a pattern like a checker board. Every ROM devices integrated in an IC (integrated circuit) is provided with contact pins corresponding to each of the data input lines, but the number of word line is too much to be provided with respective input terminals. So, there is provided only on contact pins for the word lines. And the selection of the word lines is done by applying a code to the word pin, then a decoder provided in the IC selects the word line according to the code (address) allotted to each of the word lines. Therefore, it is necessary to write one by one the data of the checker board pattern in all of the bytes. For example, in a 64 k bits memory device of 8 bits/byte, there are 8,192 memory arrays to be written. Therefore if it takes 10 ms to write a byte, it is necessary approximately 82 sec. to write a checker board pattern in a device. This time, and hence the time necessary for the test of device increases as the memory size of the device increases. So it is becoming a serious problem for manufacturer of memory device.

## SUMMARY OF THE INVENTION

It is a general object of the present invention to reduce the time to test a programmable memory device.

An object of the present invention is a method to cut down the time to write a checker board pattern in a memory matrix of a programmable memory device.

Also object of the present invention is to provide a programmable memory device, especially an EEPROM of which checker board pattern can be written in a very short time.

The advantage of the test time reduction should be attained with neither increasing the pins of conventional EEPROM nor using special test apparatus.

These objects are achieved according to claim 1 and 5 respectively.

Foregoing objects can be attained by providing a PROM device with a means to select all of the word lines, a means to select every other one out of the word lines, and a means to select all of the bit lines at a same time.

By providing the PROM device with these means it becomes possible to write the checker board pattern with only four steps, regardless to the memory scale. Each of these steps are equivalent to write or erase a word in an E²PROM. Therefore, the writing process of the checker board pattern is reduced to few tens of ms. which is equivalent to write only four bytes in the memory matrix.

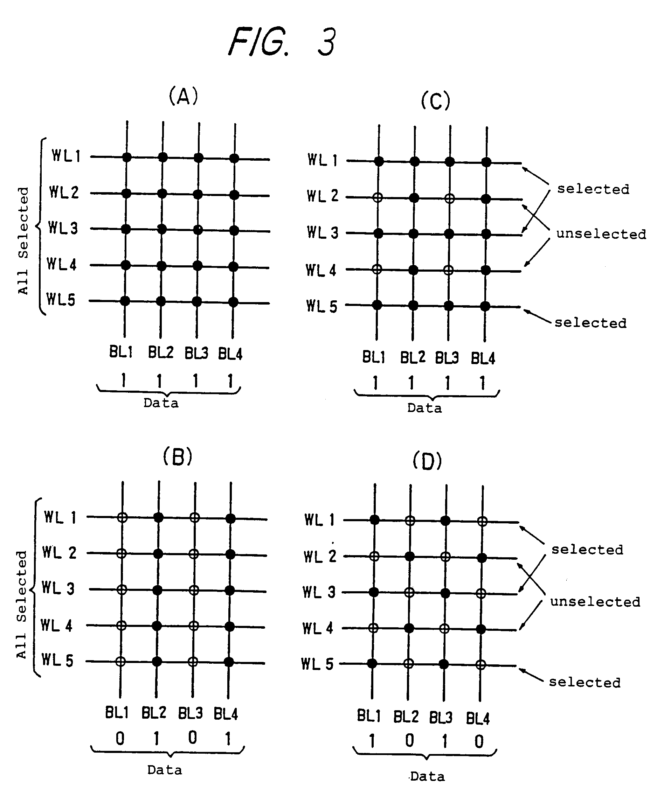

The process to write the checker board pattern will be disclosed referring to Fig. 3. The process performs following steps sequentially.

Step (A): Select all of the word lines WL1, WL2 •••, and select all of the bit lines BL1, BL2 •••. Then erase all bits in the memory matrix, and write a data "1" to all of the memory cells. So pattern of the memory matrix becomes as shown in Fig. 3(A).

Step(B): Select all of the word lines, and write to all of the bit lines alternately "0" "1" "0" "1" •••. Then, the pattern of the memory matrix becomes as shown in Fig. 3(B).

Step (C): Select the word lines every other one (odd numbered lines for example), and write to all of the bit lines "0". Accordingly, the pattern of the memory matrix becomes as shown in Fig. 3(C).

Step (D): Select the word lines every other one (odd numbered lines for example), and write to all of the bit lines an inverse data of the step (B), namely "1" "0" "1" "0" •••. Consequently, the pattern of the memory matrix becomes a checker board pattern as shown in Fig. 3(D).

As can be seen in the above explanation, each of the above steps are equivalent to write a word or one byte to a memory device. So the process time to write a checker board pattern in the memory matrix in the PROM device, and hence the time required to its check is cut down extensively. It will be clear that the above described process does not depend on the number of the word lines. So, such process is applicable to any of programmable memory matrix, regardless to its memory size.

The objects and advantage of the invention will become more apparent from the following description, reference being had to the accompanied drawings.

Fig. 1 is a schematic cross sectional view of a floating gate type memory transistor applied to the present invention.

Fig. 2 is a circuit diagram of a programmable memory device illustrating a part relevant to the present invention.

Fig. 3 is a diagram illustrating a process to write a checker board pattern in a memory matrix according to the present invention, wherein:

Fig. 3(A) illustrates a consequence of the step (A), in which all bits are erased and "1" is written in all of the memory cells.

Fig. 3(B) illustrates a consequence of the step (B), in which all bit lines are written alternately, "0" and "1".

Fig. 3(C) illustrates a consequence of the step (C), wherein the word lines are selected every other one and erased.

Fig. 3(D) illustrates a consequence of the step (D), wherein the word lines and the bit lines are selected every other one and erased. As a result, a checker board pattern is completed.

Fig. 4 is a circuit diagram of an example of a selection circuit which is applicable to the present invention to selects all of the word lines or selects every other one of them at the same time.

Fig. 5 is a circuit diagram of an example of voltage detector circuit applicable to the present invention.

Throughout the drawings, the same reference numerals designates and identify the same or similar parts.

As has been described before, the present invention intends to provide a PROM device with means to select all of the word lines, a means to select every other one out of the word lines and a means to select all of the bit lines at the same time. Various selection circuits having above functions are known in the art. The disclosure, therefore, will be given with respect to a preferred embodiment of such circuit.

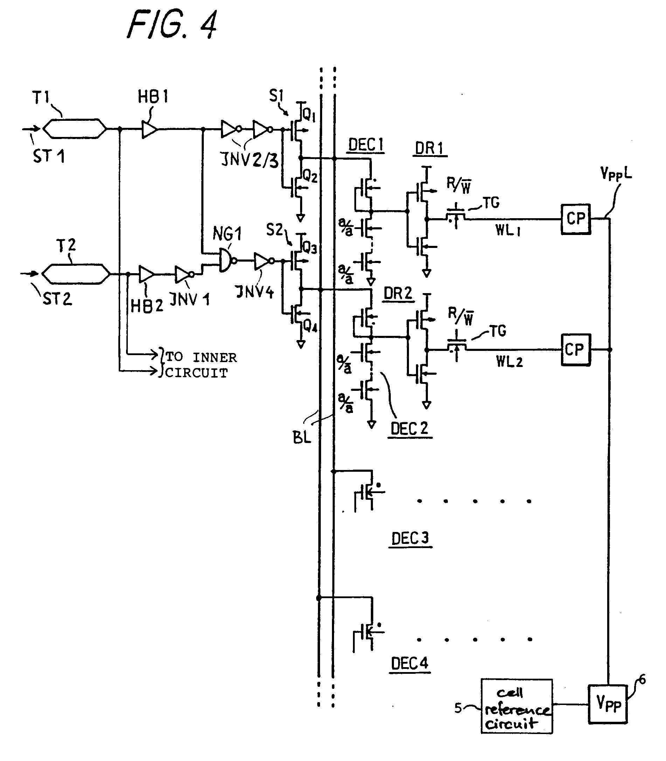

Fig. 4 is an example of a selection circuit applicable to the present invention. This circuit has both functions selecting the all of the word lines and selecting every other one out of the word lines by a control of external signal. Such circuit, therefore, is applicable for any of the means described above.

In Fig. 4, T1 and T2 are terminals to which first and second control signals ST1, ST2 are supplied. In normal operation of the device as a ROM, these terminals can be used for input or output terminals for other signals, therefore, this circuit may be added to the EEPROM device without additional input terminal. HB1 and HB2 are high voltage detection circuit which enable the terminals T1 and T2 be used for both operation of selection circuit or for the normal ROM operation. The output of HB1 is fed to a switch S1, and the output of HB2 is inverted by an inverter, and fed to one input terminal of a NAND gate. Another input terminal of the NAND gate is connected to the output terminal of HB2. Output of the Nand gate is fed to a switch S2 via an inverter.

S1 and S2 are switches composed of CMOS (complementary MOS) inverter circuit, wherein Q1, Q3 and Q2, Q4 are respectively p-channel and n-channel FETs. These switches S1 and S2 compose respectively a voltage source switch of odd numbered decoder circuits DEC1, DEC3 ••• and even numbered decoders DEC2, DEC4 •••. DR1, DR2 ••• are driver circuits composed of CMOS inverter, and are connected to respective decoder. TG are transfer gates provided between respective decoder and word line. They are composed of depletion type n-channel FET, of which gate is supplied a high voltage for the read operation, and low voltage for write operation. In the figure, $R/\overline{W}$ indicates such control signal. The decoders are controlled by a and $\overline{a}$ signals. The operation of these elements are conventional one in the art, so further description is omitted for the sake of simplicity.

As can be seen in Fig. 4, word lines are connected to respective transfer gates TG. To each of the word lines are provided a charge pump CP which increases the voltage Vpp. They are similar ones used in ordinary $E^2PROM$. The high voltage Vpp (21 volts for example) is supplied from a voltage source 6. The voltage Vpp is also fed to the cell reference circuit 5 which is the one shown in Fig. 2. In the figure, the depletion transistors are identified by small dot near the symbol of FET, and small reversed triangles imply connection to GND throughout the figures.

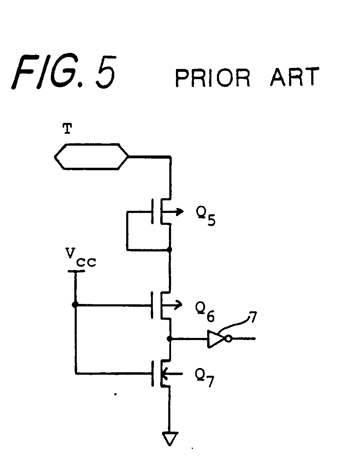

There are various high voltage detection circuits, among of which a simple and effective one is shown in Fig. 5 as an example. The circuit is composed of series connected FETs, Q5, Q6 and Q7. Among of them, Q5 and Q6 are p-channel and Q7 is an n-channel FETs. The gate of Q5 is connected to its drain, so Q5 becomes an always conductive, so it is equivalent to a small resistor. The gates of Q6 and Q7 are connected to each other and supplied with a source voltage Vcc (5 volts for example). In normal operation of the device, the voltage supplied to the input terminal T has a level of 0 - 5 volts. In such voltage level, Q6 is in OFF state and Q7 is in ON state, since their gates are supplied with Vcc. So, there appears no signal to the output terminal of the inverter 7, and the output of the inverter is kept in "H" level. If the voltage of the input terminal T is increased more than Vcc, Q6 becomes conductive, and Q7 is still in ON state. Accordingly, the output of the inverter 7 becomes "L" level.

In normal memory operation, the terminals T1 and T2 in Fig .4 are supplied with signals having a voltage level of ordinary 0 - 5 volts, so the high voltage detection circuits HB1 and HB2 does not operate. Accordingly, the input signal to the switches S1 and S2 are low level "L", and their output become high level "H". So, all of the decoders are supplied with normal source voltage, and they operate normally, on the other hand, the input signals to the terminals T1 and T2 are sent to the inner circuit such as address buffer, and the device operates as a normal ROM circuit.

In order to select all of the word lines, the voltage of the terminal T1 is increased to a high voltage that is more than Vcc, and the voltage of the terminal T2 is kept in normal voltage (0 - 5 volts). Then the input of the Switches S1 and S2 become "H" level, hence their output become "L". So, the voltage source of the all of the decoders become "L", and their output also become "L". Accordingly, all inputs of the drivers becomes "L", and their output becomes "H". Thus, all of the word lines are selected.

In order to select every other word lines, the voltages supplied to the terminals T1 and T2 are increased to a high voltage more than Vcc. Then the input of switch S1 becomes "H" and the input of the switch S2 becomes "L". So, all the decoders connected to S1 is selected, and the all of odd numbered word lines (in this example) are selected, and all of the decoders connected to S2 are not selected. At this time, since the output of the switch S2 is in "H" level, all of the decoders connected to S2 and hence the even numbered word lines are in enable state that is operable by signals applied to the decoders.

Above description has been done with respect to word lines. But it will be clear for the one in the art that the word lines in Fig. 4 may be replaced by bit lines. Therefore, the circuit of Fig. 4 is applicable to select all of the bit lines, or to select every other bit lines at the same time. It should be pointed out at this time, that as can be seen in Fig. 2, the bit lines BL are connected in parallel to all of the columns of the memory arrays, so, the selection should be done in the data input lines Di1, Di2 •••, after selecting all of the Y-gates Y1, Y2 •••. But since, the data input lines are provided with respective input terminal, the selection may be done by outer test circuit. Therefore, the circuit of Fig. 4 is applicable to select all of the Y-gates at the same time.

Moreover, it is unnecessary to provide another selection circuit like Fig. 4 exclusively for the bit lines. It will be clear for the one skilled in the art, that the selection of Y-gates can be done with only one circuit designed for the word lines. Because, all Y-gates should be selected at every step of the process described with respect to Fig. 3. So, if the lines of Y1, Y2 ••• are connected to the switch S1 like a similar manner with the word lines, they are selected every time when the word lines are selected.

Next, a process to write a checker board pattern as has been described with respect to Fig. 3 will be explained. The process performs following four steps sequentially.

Step (A): Apply high voltage more than Vcc to the terminal T1, and apply to all of the data input lines a datum "1". Then all bits are erased and a datum "1" is stored in all memory cells. The pattern of the data matrix becomes as shown in Fig. 3(A).

Step (B): Apply Vpp to the terminal T1, and apply to the data input lines alternately the data "0" "1" "0" •••. Then the pattern of the memory matrix will become as shown in Fig. 3(B).

Step (C): Apply Vpp to the terminals T1 and T2, and apply to all of the data input lines a datum "0". Then the pattern of the memory matrix will become as shown in Fig. 3(C).

Step (D): Apply Vpp to the terminals T1 and T2, and apply to all of the data input lines alternately an inverse data of the step (B) "1" "0" "1" "0" •••. As a consequence, a checker board pattern like Fig. 3(D) is written in the memory matrix.

In the above disclosure, the explanation have been done with respect to an eight bits memory array, of which memory cells are composed of a memory transistor and a FET. But it will be clear that the invention does not restricted in such device, and it can be applied to any type of memory matrix. As has been described before, there are known in the art various kinds of circuits which select the many of the circuit lines at a time, and circuits which select every other one circuit lines out of many circuit lines at a time. So, the selection circuit described with respect to Fig. 4 is an example of the circuit. Therefore, various modification of the circuit may be possible, and the embodiment described in the disclosure is not a restrictive one. The invention, therefore, is to provide an EPROM with a circuit which selects all of the word lines and bit lines at a time, and a circuit which selects every other one of the word lines at the same time, which enables to write a checker board pattern in a memory matrix with only four steps regardless to the bit size of the memory device.

**Claims**

1. A semiconductor programmable memory device having a memory matrix including memory cells (2), word lines (WL) and bit lines (BL), in which a checker board pattern can be written for testing its operation, said semiconductor programmable memory device being characterized by:

   means (3), connected to said bit lines (BL) of said memory matrix, for selecting all of bit lines (BL) at the same time during a test mode;

a selection circuit connected to said word lines (WL) of said memory matrix, for selecting, dependent on a first and a second control signal (ST1, ST2), all of word lines (WL) at the same time or selecting every other word line at the same time during the test mode, said selection circuit comprising:

a plurality of decoder circuits (DEC) and driver circuits (DR) connected to said word lines (WL);

first and second switch means (S1, S2) for selecting all the decoder and driver circuits (DEC, DR) at the same time when said first control signal (ST1) has a higher voltage than a predetermined voltage and said second control signal (ST2) has a voltage lower than said predetermined voltage, and

for selecting every other decoder circuit (DEC) at the same time when said first and second control signals are of the same voltage which is higher than said predetermined voltage,

wherein write operation is performed in a memory cell connected to said selected word lines (WL) and said selected bit lines (BL).

2. A semiconductor programmable memory device according to claim 1, said selection circuit comprising:

first and second input terminals (T1 and T2) for receiving said first and second control signals (ST1, ST2), respectively, from an external control source;

a first high voltage detection circuit (HB1) coupled to said first input terminal (T1) detecting the first control signal input to the first input terminal (T1);

a second high voltage detection circuit (HB2) coupled to said second input terminal (T2) detecting the second control signal input to the second input terminal (T2);

said first switch means (S1) coupled to said first high voltage detection circuit (HB1) through inverters (INV2, INV3);

a NAND gate (NG1) having a plurality of inputs and an output, one of said inputs of said NAND gate (NG1) is coupled to the output of said second high voltage detection circuit (HB2) through an inverter (INV1), and another input of said NAND gate (NG1) is coupled to the output of said first high voltage detection circuit (HB1);

said second switch means (S2) coupled to said output of said NAND gate (NG1) through an inverter (INV4);

said plurality of decoder and driver circuits each having an input and an output, said first switch means (S1) being connected to the input of every other decoder (DEC1, DEC3, ...) and driver circuit (DR1, DR3, ...), said second switch means (S2) being connected to the input of the remaining decoder (DEC2, DEC4, ...) and driver circuits (DR2, DR4, ...), and said word lines being respectively connected to the output of said decoder (DEC) and driver (DR) circuits, so that all of said word lines (WL) are selected at the same time, when the first control signal is above a predetermined voltage and the second control signal is below the predetermined voltage, and every other word line (WL) is selected at the same time, when the first and second control signals are above the predetermined voltage.

3. A semiconductor programmable memory device according to claim 2, wherein said memory device is a PROM.

4. A semiconductor programmable memory device according to claim 2, wherein said memory device is an E$^2$PROM.

5. A method of writing a checkerboard pattern in a memory matrix of a semiconductor programmable memory device having a plurality of word lines and plurality of bit lines characterized in that

said memory device comprises a selection circuit for selecting all word lines (WL) or every other word line, and

said method comprises the steps of:

(a) selecting all of the bit lines (BL) and hold them selected;

(b) selecting all of the word lines (WL) at the same time and writing a data "1" to all of the bit lines (BL) for erasing all bits in said memory matrix, whereby said selecting is performed by applying a first control signal (ST1) of a voltage higher than a predetermined voltage and a second control signal (ST2) of a voltage lower than said predetermined voltage to said selection circuit;

(c) selecting all of the word lines (WL) at the same time and writing to all of the bit lines (BL) alternately data of "0" and "1" whereby said selecting is performed by applying said control signals as in step (b);

(d) selecting every other word line (WL) at the same time and writing to all of the bit lines a data "1" whereby said selecting is performed by applying same first and second control signals of a voltage higher than said predetermined voltage to said selection circuit; and

(e) selecting every other word line (WL) at the same time by applying said first and second control signals as in the step (d), and writing to every other bit lines (BL) the inverse data of the step (c).

**Patentansprüche**

1. Programmierbare Halbleiterspeicheranordnung mit einer Speichermatrix, die Speicherzellen (2), Wortleitungen (WL) und Bitleitungen (BL) einschließt, in die ein Schachbrettmuster eingeschrieben werden kann, um deren Funktion zu prüfen, wobei die programmierbare Halbleiterspeicheranordnung gekennzeichnet ist durch

Mittel (3), die mit den genannten Bitleitungen (BL) der genannten Speichermatrix verbunden sind, um alle Bitleitungen (BL) zur selben Zeit während eines Testmodus auszuwählen;

eine Auswahlschaltung, die mit den genannten Wortleitungen (WL) der genannten Speichermatrix verbunden ist, um in Abhängigkeit eines ersten und zweiten Steuersignals (ST1, ST2) alle Wortleitungen (WL) zur selben Zeit auszuwählen oder um jede zweite Wortleitung zur selben Zeit während eines Testmodus auszuwählen, wobei die Auswahlschaltung umfaßt:

eine Vielzahl von Dekoderschaltungen (DEC) und Treiberschaltungen (DR), die mit den genannten Wortleitungen (WL) verbunden sind;

erste und zweite Schalteinrichtungen (S1, S2) um alle Dekoder- und Treiberschaltungen (DEC, DR) zur selben Zeit auszuwählen, wenn das erstgenannte Steuersignal (ST1) eine höhere Spannung als eine vorbestimmte Spannung und das zweite Steuersignal (ST2) eine niedrigere Spannung als die genannte vorbestimmte Spannung hat, und um jede zweite Dekoderschaltung (DEC) zur selben Zeit auszuwählen, wenn das genannte erste und zweite Steuersignal dieselbe Spannung aufweisen, welche höher ist als die genannte vorbestimmte Spannung,

wobei ein Einschreibvorgang in einer Speicherzelle ausgeführt wird, die mit den genannten ausgewählten Wortleitungen (WL) und den genannten ausgewählten Bitleitungen (BL) verbunden ist.

2. Programmierbare Halbleiterspeicheranordnung nach Anspruch 1, wobei die genannnte Auswahlschaltung umfaßt:

erste und zweite Eingangsterminals (T1 und T2) zum Empfang des genannten ersten bzw. zweiten Steuersignals (ST1, ST2) von einer externen Steuerquelle;

eine erste Schaltung (HB1) zur Ermittlung der hohen Spannung, die mit dem genannten Eingangsterminal (T1) verbunden ist, welche den ersten Steuersignalseingang zum ersten Eingangsterminal (T1) detektiert;

eine zweite Schaltung (HB2) zur Ermittlung der hohen Spannung, die mit dem zweiten Eingangsterminal (T2) verbunden ist, welche den zweiten Steuersignaleingang zum zweiten Eingangsterminal (T2) detektiert;

wobei die erste Schalteinrichtung (S1) durch Inverter (INV2, INV3) mit der ersten Schaltung (HB1) zur Ermittlung der hohen Spannung verbunden ist;

ein NAND-Gatter (NG1), das eine Vielzahl von Eingängen und einen Ausgang hat, wobei einer der genannten Eingänge des genannten NAND-Gatters (NG1) mit dem Ausgang der genannten zweiten Schaltung (HB2) zur Ermittlung der hohen Spannung über einen Inverter (INV1) verbunden ist, und wobei ein anderer Eingang des genannten NAND-Gatters (NG1) mit dem Ausgang der genannten ersten Schaltung (HB1) zur Ermittlung der hohen Spannung verbunden ist;

wobei die zweite Schalteinrichtung (S2) mit dem Ausgang des genannten NAND-Gatters (NG1) durch einen Inverter (INV4) verbunden ist;

wobei die Vielzahl von Dekoder- und Treiber-Schaltungen jeweils einen Eingang und einen Ausgang haben, wobei die genannte erste Schalteinrichtung (S1) verbunden ist zum Eingang jeder zweiten Dekoder- (DEC1, DEC3, ...) und Treiber-Schaltung (DR1, DR3, ...), wobei die genannte zweite Schalteinrichtung (S2) verbunden ist mit dem Eingang der verbleibenden Dekoder- (DEC2, DEC4, ...) und Treiberschaltungen (DR2, DR4, ...), und wobei die genannten Wortleitungen entsprechend verbunden sind mit dem Ausgang der genannten Dekoder- (DEC) und Treiber- (DR) Schaltungen, so daß alle genannten Wortleitungen (WL) zur selben Zeit ausgewählt werden, wenn das erste Steuersignal über einer vorbestimmten Spannung und das zweite Steuersignal unter der vorbestimmten Spannung ist und jede zweite Wortleitung (WL) zur selben Zeit ausgewählt wird, wenn das erste und zweite Steuersignal über der vorbestimmten Spannung sind.

3. Programmierbare Halbleiterspeicheranordnung nach Anspruch 2, wobei die genannte Speicheranordnung ein PROM ist.

4. Programmierbare Halbleiterspeicheranordnung nach Anspruch 2, wobei die genannten Speicheranordnung ein E² PROM ist.

5. Verfahren zum Einschreiben eines Schachbrettmusters in eine Speichermatrix einer programmierbaren Halbleiterspeicheranordnung, die eine Vielzahl von Wortleitungen und Bitleitungen aufweist,

dadurch gekennzeichnet,

daß die genannte Speicheranordnung eine Auswahlschaltung zur Auswahl aller Wortleitungen (WL) oder jeder zweiten Wortleitung umfaßt, und

wobei das Verfahren die Schritte umfaßt:

(a) Auswahl aller Bitleitungen (BL) und diese ausgewählt halten;

(b) Auswahl aller Wortleitungen (WL) zur selben Zeit und Einschreiben der Daten "1" in alle Bitleitungen (BL), um alle Bits in der genannten Speichermatrix zu löschen, wobei die genannte Auswahl durchgeführt wird, indem ein erstes Steuersignal (ST1) einer höheren Spannung als eine vorbestimmte Spannung und ein zweites Steuersignal (ST2) mit einer niedrigeren Spannung als die genannte vorbestimmte Spannung an die genannte Auswahlschaltung angelegt wird;

(c) Auswahl aller Wortleitungen (WL) zur selben Zeit und Einschreiben von abwechselnden Daten "0" und "1" in alle Bitleitungen, wobei die genannte Auswahl durch Anwendung der genannten Steuersignals wie bei Schritt (b) durchgeführt wird;

(d) Auswahl jeder zweiten Wortleitung (WL) zur selben Zeit und Einschreiben in alle Bitleitungen von Daten "1", wobei die genannte Auswahl durchgeführt wird durch Anwenden des genannten ersten und zweiten Steuersignals, welche eine höhere Spannung haben als die genannte vorbestimmte Spannung der genannten Auswahlschaltung ist; und

(e) Auswahl jeder zweiten Wortleitung (WL) zur selben Zeit durch Anwenden des genannten ersten und zweiten Steuersignals wie im Schritt (d), wobei in alle zweiten Bitleitungen (BL) die inversen Daten des Schrittes (c) eingeschrieben werden.

**Revendications**

1. Dispositif de mémoire programmable à semiconducteur comportant une matrice de mémoire incluant des cellules de mémoire (2), des fils de mot (WL) et des fils de bit (BL), dans lequel une configuration en damier peut être écrite pour le test de son fonctionnement, ledit dispositif de mémoire programmable à semiconducteur étant caractérisé par:

un moyen (3), connecté auxdits fils de bit (BL) de ladite matrice de mémoire, pour sélectionner l'ensemble des fils de bit (BL) en même temps pendant un mode de test;

un circuit de sélection connecté auxdits fils de mot (WL) de ladite matrice de mémoire, pour sélectionner, selon un premier et un second signal de commande (ST1, ST2), l'ensemble des fils de mot (WL) en même temps ou pour sélectionner tout autre fil de mot en même temps pendant le mode de test, ledit circuit de sélection comprenant:

une pluralité de circuits décodeurs (DEC) et de circuits de commande (DR) connectés auxdits fils de mot (WL);

des premier et second moyens commutateurs (S1,S2) pour sélectionner l'ensemble des circuits décodeurs et de commande (DEC,DR) en même temps quand ledit premier signal de commande (ST1) a une tension supérieure à une tension prédéterminée et ledit second signal de commande (ST2) a une tension inférieure à ladite tension prédéterminée, et

pour sélectionner tout autre circuit décodeur (DEC) en même temps quand lesdits premier et second signaux de commande ont la même tension qui est supérieure à ladite tension prédéterminée,

dans lequel l'opération d'écriture est exécutée dans une cellule de mémoire connectée auxdits fils de mot (WL) sélectionnés et auxdits fils de bit (BL) sélectionnés.

2. Dispositif de mémoire programmable à semiconducteur selon la revendication 1, ledit circuit de sélection comprenant:

des première et seconde bornes d'entrée (T1 et T2) pour recevoir lesdits premier et second signaux de commande (ST1,ST2), respectivement, d'une source de commande externe;

un premier circuit de détection de tension de niveau haut (HB1) couplé à ladite première borne d'entrée (T1) détectant le premier signal de commande entré par la première borne d'entrée (T1);

un second circuit de détection de tension de niveau haut (HB2) couplé à ladite seconde borne d'entrée (T2) détectant le second signal de commande entré par la seconde borne d'entrée (T2);

ledit premier moyen commutateur (S1) couplé audit premier circuit de détection de tension de niveau haut (HB1) par l'intermédiaire d'inverseurs (INV2,INV3);

une porte NON-ET (NG1) comportant une pluralité d'entrées et une sortie, une desdites entrées de ladite porte NON-ET (NG1) étant couplée à la sortie dudit second circuit de détection de tension de niveau haut (HB2) par l'intermédiaire d'un inverseur (INV1), et une autre entrée de ladite porte NON-ET (NG1) étant couplée à la sortie dudit premier circuit de détection de tension de niveau haut (HB1);

ledit second moyen commutateur (S2) couplé à ladite sortie de ladite porte NON-ET (NG1) par l'intermédiaire d'un inverseur (INV4);

ladite pluralité des circuits décodeurs et de commande comportant chacun une entrée et une sortie, ledit premier moyen commutateur (S1) étant connecté à l'entrée de tout autre circuit décodeur (DEC1,DEC3,...) et de tout autre circuit de commande (DR1,DR3,...), ledit second moyen commutateur (S2) étant connecté à l'entrée des circuits décodeurs (DEC2,DEC4,...) et de commande (DR2,DR4,...) restants, et lesdits fils de mot étant respectivement connectés à la sortie desdits circuits décodeurs (DEC) et de commande (DR), de telle sorte que l'ensemble desdits fils de mot (WL) sont sélectionnés en même temps, quand le premier signal de commande est au-dessus d'une tension prédéterminée et le second signal de commande est au-dessous de la tension prédéterminée, et tout autre fils de mot (WL) est sélectionné en même temps, quand les premier et second signaux de commande sont au-dessus de la tension prédéterminée.

3. Dispositif de mémoire programmable à semiconducteur selon la revendication 2, dans lequel ledit dispositif de mémoire est une mémoire morte programmable PROM.

4. Dispositif de mémoire programmable à semiconducteur selon la revendication 2, dans lequel ledit dispositif de mémoire est une mémoire morte programmable effaçable électriquement $E^2$PROM.

5. Procédé pour écrire une configuration en damier dans une matrice de mémoire d'un dispositif de mémoire programmable à semiconducteur comportant une pluralité de fils de mot et une pluralité de fils de bit,
   caractérisé en ce que
   ledit dispositif de mémoire comprend un circuit de sélection pour sélectionner l'ensemble des fils de mot (WL) ou tout autre fil de mot, et
   ledit procédé comprend les étapes qui consistent à:
   (a) sélectionner l'ensemble des fils de bit (BL) et les maintenir sélectionnés;

(b) sélectionner l'ensemble des fils de mot (WL) en même temps et écrire une donnée "1" sur l'ensemble des fils de bit (BL) pour effacer tous les bits dans ladite matrice de mémoire, ladite sélection étant ainsi exécutée en appliquant un premier signal de commande (ST1) d'une tension supérieure à une tension prédéterminée et un second signal de commande (ST2) d'une tension inférieure à ladite tension prédéterminée audit circuit de sélection;
(c) sélectionner l'ensemble des fils de mot (WL) en même temps et écrire sur l'ensemble des fils de bit (BL) alternativement les données "0" et "1", ladite sélection étant ainsi exécutée en appliquant lesdits signaux de commande comme dans l'étape (b);
(d) sélectionner tout autre fil de mot (WL) en même temps et écrire sur l'ensemble des fils de bit une donnée "1", ladite sélection étant ainsi exécutée en appliquant les mêmes premier et second signaux de commande d'une tension supérieure à ladite tension prédéterminée audit circuit de sélection ; et à
(e) sélectionner tout autre fil de mot (WL) en même temps en appliquant lesdits premier et second signaux de commande comme dans l'étape (d), et écrire sur tout autre fil de bit (BL) la donnée inverse de l'étape (c).

## *FIG. 1*   PRIOR ART

# FIG. 2

PRIOR ART

CELL REFERENCE CIRCUIT — 5

R: 2V
E: 21V
W: 0V

# FIG. 3

(A)

(C)

(B)

(D)

# FIG. 4

# *FIG.*5    PRIOR  ART